# EUROPÄISCHE PATENTANMELDUNG

(11) **EP 3 490 070 A1**
(43) Veröffentlichungstag der Anmeldung: **29.05.2019**
(21) Anmeldenummer: 17203778.0
(22) Anmeldetag: 27.11.2017
(51) Int. Cl.: H01R 4/30, H01R 31/06, H01R 9/18, H01R 11/12

(54) **KABELANSCHLUSSELEMENT**

(71) Anmelder: Siemens Aktiengesellschaft, 80333 München (DE)
(72) Erfinder: Müller, Volker, 90408 Nürnberg (DE)

(57) **Zusammenfassung**

Die Erfindung betrifft ein Kabelanschlusselement (1) mit einer elektrischen Kontaktfläche (11) und einer Montagefläche (12), wobei die elektrische Kontaktfläche (11) mit einem Kabelschuh kontaktierbar ist, wobei das Kabelanschlusselement (1) an der Montagefläche an einem Körper (20) befestigbar ist. Zur Verbesserung des Kabelanschlusselements (1) wird vorgeschlagen, dass die elektrische Kontaktfläche (11) und die Montagefläche (12) derart an dem Kabelanschlusselement (1) angeordnet sind, dass die Ebene (110) der elektrischen Kontaktfläche (11) und die Ebene (120) der Montagefläche (12) sich schneiden. Die Erfindung betrifft weiter eine elektrische Komponente (2), insbesondere einen Stromrichter (3), mit einem derartigen Kabelanschlusselement (1), wobei das Kabelanschlusselement (1) an der Montagefläche (12) mit der elektrischen Komponente (2) verbunden ist. Ferner betrifft die Erfindung einen Schaltschrank (4) mit mindestens einer derartigen elektrischen Komponente (2).

## Beschreibung

Die Erfindung betrifft ein Kabelanschlusselement mit einer elektrischen Kontaktfläche und einer Montagefläche, wobei die elektrische Kontaktfläche mit einem Kabelschuh kontaktierbar ist, wobei das Kabelanschlusselement an der Montagefläche an einem Körper befestigbar ist. Die Erfindung betrifft weiter eine elektrische Komponente mit einem derartigen Kabelanschlusselement. Ferner betrifft die Erfindung einen Schaltschrank mit mindestens einer derartigen elektrischen Komponente.

Elektrische Komponenten werden zum Austausch mit elektrischer Energie zumeist mit Kabeln über Anschlusselemente, auch als Kabelanschlusselement oder Anschlüsse bezeichnet, kontaktiert. Dabei kann das Kabelanschlusselement beispielsweise zur Aufnahme eines Kabelschuhs ausgebildet sein oder alternativ als Anschlussschiene oder Stromschiene beispielsweise zur Aufnahme mehrerer Kabelschuhe. Ein Beispiel für eine elektrische Komponente ist ein Stromrichter. Bei größeren Komponenten, die in einem Schaltschrank angeordnet sind, wie beispielsweise Stromrichtern erfolgt der Kabelzugang oftmals entweder von unten (typischerweise durch den Schrankboden) oder von oben (typischerweise durch das Schrankdach). Die Kabel haben an ihren Enden Kabelschuhe, welche an den Anschlüssen mittels Schrauben flach angeschraubt werden. Je größer die Leistung der elektrischen Komponente ist, desto dicker und unflexibler sind die Kabel. Gerade bei mehreren Kabeln, wie beispielsweise bei einer Energieversorgung aus einem dreiphasigen Drehstromnetz, müssen die Kabel während der Montage gebogen werden, was zum einen die Montage erschwert als auch aufgrund minimaler Biegeradien einen großen Platzbedarf im erfordert.

Der Erfindung liegt die Aufgabe zugrunde, ein Kabelanschlusselement zu verbessern.

Diese Aufgabe wird durch ein Kabelanschlusselement mit einer elektrischen Kontaktfläche und einer Montagefläche gelöst, wobei die elektrische Kontaktfläche mit einem Kabelschuh kontaktierbar ist, wobei das Kabelanschlusselement an der Montagefläche an einem Körper befestigbar ist, wobei die elektrische Kontaktfläche und die Montagefläche derart an dem Kabelanschlusselement angeordnet sind, dass die Ebene der elektrischen Kontaktfläche und die Ebene der Montagefläche sich schneiden. Ferner wird die Aufgabe durch eine elektrische Komponente mit einem derartigen Kabelanschlusselement gelöst, wobei das Kabelanschlusselement an der Montagefläche mit einem Körper der elektrischen Komponente verbunden ist.

Vorteilhafte Ausgestaltungen der Erfindung sind in den abhängigen Ansprüchen angegeben.

Der Erfindung liegt die Erkenntnis zugrunde, dass durch die geneigte Lage der elektrischen Kontaktfläche gegenüber der Montagefläche deutlich weniger Raum für die Biegung des oder der Kabel benötigt wird und/oder die Biegung des oder der Kabel deutlich geringer ausfallen kann. Dabei kann die elektrische Kontaktfläche zur Verbindung mit einem Kabelschuh oder, beispielsweise als Anschlussschiene, zur Aufnahme von einer Vielzahl von Kabelschuhen ausgebildet sein. Während bei den standardmäßig vorkommenden geraden Kabelanschlusselementen ohne Neigung mehrfache Biegungen, beispielsweise in einem S-förmiger Verlauf, des Kabels entstehen, passt sich durch die geneigte Lage der elektrischen Kontaktfläche der Kabelverlauf in einem stärkeren Maß an den natürlichen Verlauf des Kabels an. Dadurch werden Biegungen in Anzahl und Ausmaß im Kabel reduziert. Durch die reduzierte Anzahl der Biegungen im Kabel werden darüber hinaus die mechanischen Spannungen im Kabel reduziert. Dies senkt die auf das Kabelanschlusselement übertragenen Kräfte, so dass der Anschluss einfacher, insbesondere kleiner und kostengünstiger, ausgeführt werden kann.

Besonders vorteilhaft ist die Möglichkeit, mit geraden Standardkabelschuhen einen deutlich kompakteren Kabelanschlussraum zu realisieren und dabei gleichzeitig die am Kabelanschluss auftretenden Kräfte zu reduzieren. Auch kann durch Variation des Anstellwinkels der für die Anwendung optimale Anstellwinkel genutzt werden.

Gegenüber einer am Markt befindlichen alternativen Lösung mit der Verwendung von Kabelschuhen mit schräger Anschlusslasche ist es bei dem erfindungsgemäßen Anschlusselement möglich, Standardkabelschuhe zu verwenden. Gerade bei unterschiedlichen Anstellwinkeln bei verschiedenen Kabelanschlusselementen an einer elektrischen Komponente ist die Verwendung gleichartiger Kabelschuhe gerade im Hinblick auf die Verwendung von Gleichteilen besonders vorteilhaft. Dies ermöglicht es, die gleichen Vorteile zu erreichen. Ebenso können auf einfache Weise auch spezielle Kabelendverschlüssen verwendet werden, die nur in geringen Ausprägungen am Markt verfügbar sind.

Die elektrische Komponente dient dabei als Körper, an dem das Kabelanschlusselement befestigt wird. Die Befestigung kann beispielsweise an der Oberfläche der elektrischen Komponente geschehen. Bei der elektrischen Komponente kann es sich beispielsweise um einen Stromrichter handeln. Dieser kann in einem Schaltschrank angeordnet sein. Möglich ist auch, dass sich die elektrische Komponente außerhalb eines Schaltschrankes befindet. Gerade in einem Schaltschrank sind die Platzverhältnisse zumeist sehr beschränkt, so dass nur wenig Raum für die Führung der Kabel verbleibt, der mit dem Kabelanschlusselement bestmöglich ausgenutzt wird.

Mittels des Kabelanschlusselementes wird elektrische Energie zwischen einem Kabel und Komponenten im Innern der elektrischen Komponente übertragen. Bei den Komponenten im Innern der elektrischen Komponente kann es sich beim Beispiel des Stromrichters um Halbleiterbauelemente handeln, mit denen eine elektrische Verbindung hergestellt wird.

Das Kabelanschlusselement kann einteilig ausgeführt sein und dabei zwischen der Ebene der elektrischen Kontaktfläche und der Ebene der Montagefläche einen Winkel α aufweisen. Alternativ ist es auch möglich, dass das Kabelanschlusselement mehrteilig, insbesondere zweiteilig ausgeführt ist. Dabei dient ein erster leitender Teil zur Verbindung mit dem Kabel während ein zweiter Teil, beispielsweise als Adapter, zur Befestigung am Körper dient. Bei dem Körper kann es sich beispielsweise um ein Gehäuse oder einer weiteren Montagefläche eines Stromrichters handeln. Dabei kann der Adapter derart ausgebildet sein, dass nach dem Zusammenfügen der beiden Teile des Kabelanschlusselements die Ebene der elektrischen Kontaktfläche und die Ebene der Montagefläche sich schneiden.

Bei einer vorteilhaften Ausgestaltung der Erfindung schneiden sich die Ebene der elektrischen Kontaktfläche und die Ebene der Montagefläche in einem Winkel im Bereich zwischen 5° und 45°. Dieser Winkel wird auch als Anstellwinkel bezeichnet. Um die Biegung des Kabels möglichst gering zu halten, haben sich ein geneigtes Anschlusselement bzw. eine geneigte Anschlussschiene mit einem Anstellwinkel in dem genannten Bereich als besonders vorteilhaft bei der Kabelführung erwiesen. Damit kann eine Kabelführung in der Nähe der elektrischen Komponente vermieden werden und ein hinreichender Abstand zwischen Kabel und elektrischer Komponente sichergestellt werden.

Bei einer weiteren vorteilhaften Ausgestaltung der Erfindung weist die elektrische Komponente mindestens drei Kabelanschlusselemente auf. Drei Kabel sind für einen Anschluss an ein dreiphasiges Drehstromnetz erforderlich. Gerade elektrische Komponenten mit großer Leistung, beispielsweise oberhalb 100kW, werden häufig aus einem Drehstromnetz mit elektrischer Energie versorgt. Gleichzeitig sind aufgrund der hohen Leistung derart große Kabelquerschnitte erforderlich, welche die Biegsamkeit der Kabel herabsetzt. Teilweise sind darüber hinaus Mindestradien bei der Biegung der Kabel einzuhalten. Bei der Verwendung von elektrischen Kontaktflächen, die parallel zur Oberfläche des Gehäuses ausgerichtet sind, ist ein großer Abstand zwischen den einzelnen Kabelanschlusselementen vorzusehen, damit die Kabelwege der einzelnen Kabel sich nicht gegenseitig behindern. Durch die geneigte Lage der elektrischen Kontaktfläche können die Kabelanschlusselemente deutlich näher zueinander angeordnet werden, da die Kabel nicht gebogen werden müssen, um die anderen übrigen Anschlusselemente nicht zu verdecken. Dadurch kann ein besonders räumlich kompakter Anschluss der Kabel an die elektrische Komponente erfolgen, ohne starke Biegungen im Kabel vorsehen zu müssen. Gleichzeitig sind die auftretenden mechanischen Kräfte relativ gering. Somit ist es beispielsweise möglich, die einzelnen Kabelanschlusselemente in einem Abstand zwischen 5cm und 20cm beabstandet zueinander anzuordnen.

Dabei hat es sich als besonders vorteilhaft erwiesen, wenn der Anstellwinkel der unterschiedlichen Kabelanschlusselemente sich unterscheidet. Damit können auf einfache Weise die unterschiedlichen Kabelverläufe der einzelnen Kabel mit geringen Biegungen realisiert werden.

Bei einer weiteren vorteilhaften Ausgestaltung der Erfindung schneiden sich die Ebene der elektrischen Kontaktfläche und die Ebene der sich in der Umgebung der elektrischen Kontaktfläche befindlichen Oberfläche der elektrischen Komponente, insbesondere schneiden sie sich in einem weiteren Winkel im Bereich zwischen 5° und 45°. Die Vorteile des Kabelanschlusselementes kommen insbesondere dann zur Geltung, wenn die elektrische Kontaktfläche gegenüber der Oberfläche des Gehäuses der elektrischen Komponenten, die sich in unmittelbarer Umgebung des Kabelanschlusselementes befindet, geneigt ist. Dies ist insbesondere dann der Fall, wenn die elektrische Komponente oder die elektrischen Komponenten in räumlich stark eingeschränkter Umgebung angeordnet werden, wie es beispielsweise in einem Schaltschrank der Fall ist. Damit lässt sich eine besonders platzsparende Anordnung erzielen, da sich auf einfache Weise unterschiedliche Kabelverläufe der einzelnen Kabel mit nur geringen Biegungen der Kabel realisieren lassen.

Im Folgenden wird die Erfindung anhand der in den Figuren dargestellten Ausführungsbeispiele näher beschrieben und erläutert. Es zeigen:
- FIG 1: einen Anschluss aus dem Stand der Technik
- FIG 2: ein Kabelanschlusselement,
- FIG 3, FIG 4: Ausführungsbeispiele für ein Kabelanschlusselement mit geneigter elektrischer Kontaktfläche und
- FIG 5: einen Stromrichter mit geneigten Kabelanschlusselementen.

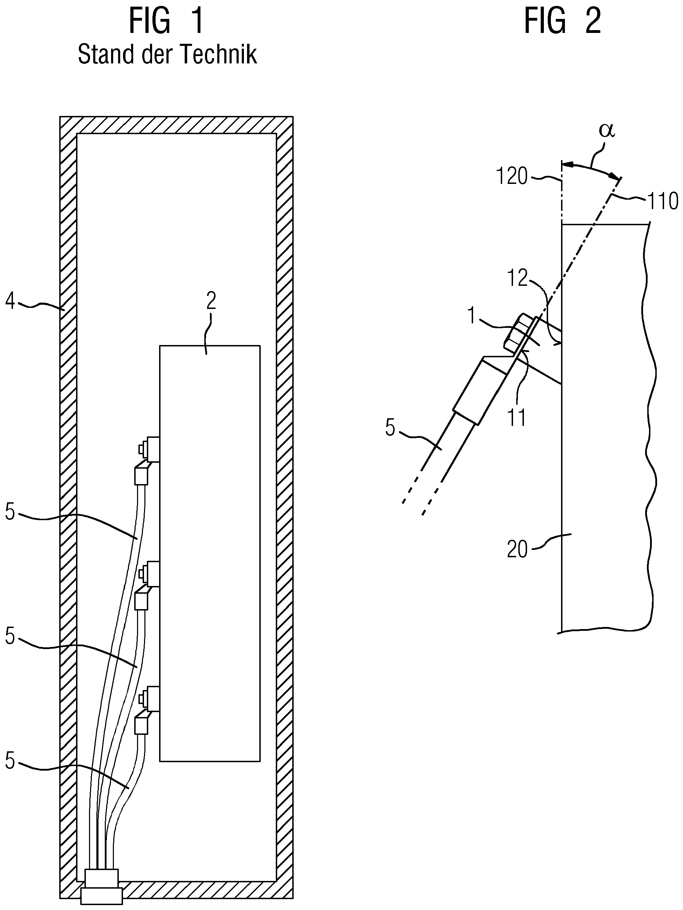

Die FIG 1 zeigt eine aus dem Stand der Technik bekannte Anordnung mit einem Schaltschrank 4, in dem eine elektrische Komponente 2 angeordnet ist. Diese elektrische Komponente 2 wird über drei Kabel 5 mit elektrischer Energie versorgt. Die Kabel 5 sind über Anschlusselemente mit der elektrischen Komponente 2 verbunden. Die Kontaktfläche ist gegenüber der Fläche der elektrischen Komponente 2, an der die Anschlusselemente an der elektrischen Komponente 2 angebracht sind, parallel ausgerichtet. Dadurch sind die Kabel 5 S-förmig gebogen, um die Anschlusselemente der anderen Kabel 5 nicht zu verdecken und gleichzeitig durch die Durchführung im Schaltschrank 4 geführt werden zu können.

Die FIG 2 zeigt ein Kabelanschlusselement 1. An der elektrischen Kontaktfläche 11 des Kabelanschlusselementes 1 ist das Kabel 5 beispielsweise mittels eines Kabelschuhs und einer Schraube befestigt. Das Kabelanschlusselement 1 ist an der Montagefläche 12 mechanisch mit einem Körper 20 verbunden. Dabei ist die Ebene 110 der elektrischen Kontaktfläche 11 zur Ebene 120 der Montagefläche 12 geneigt. Das heißt, die Ebene 110 der elektrischen Kontaktfläche 11 und die Ebene 120 der Montagefläche 12 schneiden sich in einem Winkel α. Dieser Winkel α wird auch als Anstellwinkel bezeichnet.

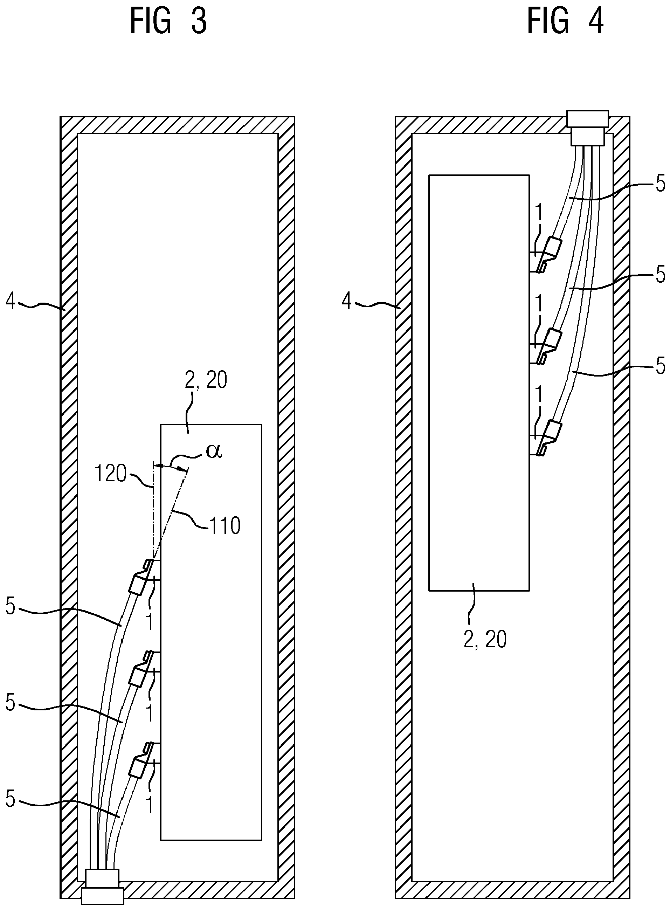

Die FIG 3 zeigt ein Ausführungsbeispiel eines Schaltschrankes 4, in dem eine elektrische Komponente 2 angeordnet ist. Dabei wird auch hier die elektrische Komponente 2 über drei Kabel 5 mit elektrischer Energie versorgt. Jedoch erfolgt die elektrische Verbindung mit der elektrischen Komponente 2 mittels jeweils eines Kabelanschlusselements 1 nach FIG 2. Dabei stellt der Körper 20 in diesem Ausführungsbeispiel die elektrische Komponente 2 dar. Das Kabelanschlusselement 1 weist dabei die elektrische Kontaktfläche 11 zur Verbindung mit dem Kabel 5 auf, die gegenüber der Montagefläche 12, an der das Kabelanschlusselement 1 mit der elektrischen Komponente 2 befestigt ist, geneigt ist. Durch diese Neigung um den Winkel α können die Kabel 5 mit weniger Biegungen auf dem Weg von der Kabeldurchführung des Schaltschrankes 4 zu dem Kabelanschlusselement 1 geführt werden. Ebenso reduzieren sich damit die vom Kabel 5 auf das Kabelanschlusselement 1 übertragenen mechanischen Kräfte. Dabei kann die Kabeldurchführung am Boden des Schaltschrankes 4 angeordnet sein, wie in FIG 3 dargestellt, oder entsprechend FIG 4 am Dach des Schaltschrankes 4. Bezüglich der FIG 4 wird auf die Beschreibung zur FIG 3 sowie auf die dort eingeführten Bezugszeichen verwiesen.

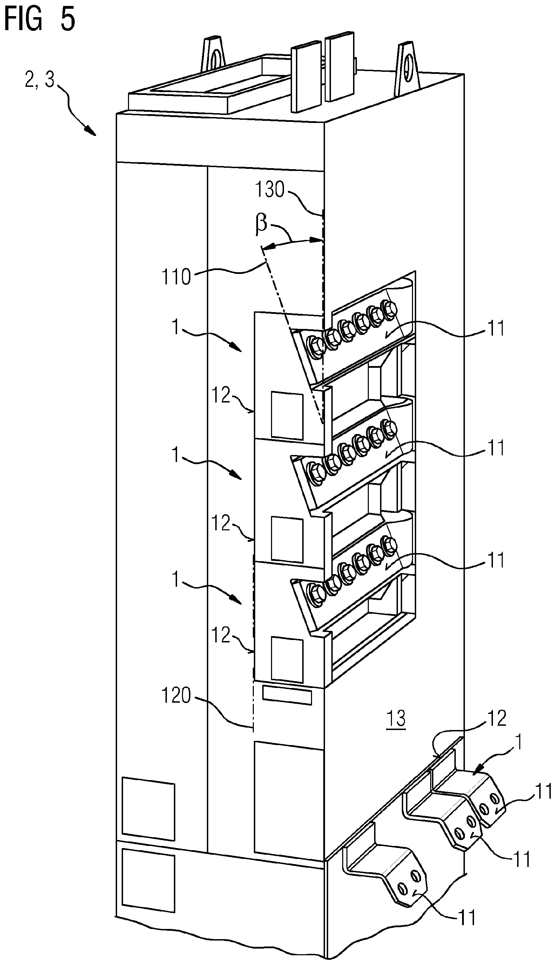

Die FIG 5 zeigt einen Stromrichter 3 als elektrische Komponente 2. Die elektrischen Anschlüsse sind als Kabelanschlusselemente 1 ausgeführt, bei der die elektrische Kontaktfläche 11 gegenüber der Montagefläche 12 geneigt ist. Dabei ist die Ebene 120 der Montagefläche 12 gegenüber der Ebene 130 in der Umgebung der elektrischen Kontaktfläche 11 befindlichen Oberfläche der elektrischen Komponente 2 zueinander versetzt angeordnet. Diese versetzte Anordnung kann dabei parallel versetzt angeordnet sein oder auch einen Winkel zueinander aufweisen. Die Ebene 110 der elektrischen Kontaktfläche 11 und die Ebene 130 der in der Umgebung der elektrischen Kontaktfläche 11 befindlichen Oberfläche der elektrischen Komponente 2 schneiden sich dabei in einem weiteren Winkel β. Dies ermöglicht eine besonders vorteilhafte Kabelführung, da durch diesen weiteren Winkel β auch ohne starke Biegungen der hier nicht dargestellten Kabel der Kabelverlauf auf einfache Weise in einem gewünschten Abstand zur Oberfläche, insbesondere zu der in der Umgebung der elektrischen Kontaktfläche 11 befindlichen Oberfläche, des Stromrichters 3 erfolgen kann.

Zusammenfassend betrifft die Erfindung ein Kabelanschlusselement mit einer elektrischen Kontaktfläche und einer Montagefläche, wobei die elektrische Kontaktfläche mit einem Kabelschuh kontaktierbar ist, wobei das Kabelanschlusselement an der Montagefläche an einem Körper befestigbar ist. Zur Verbesserung des Kabelanschlusselements wird vorgeschlagen, dass die elektrische Kontaktfläche und die Montagefläche derart an dem Kabelanschlusselement angeordnet sind, dass die Ebene der elektrischen Kontaktfläche und die Ebene der Montagefläche sich schneiden. Die Erfindung betrifft weiter eine elektrische Komponente, insbesondere einen Stromrichter, mit einem derartigen Kabelanschlusselement, wobei das Kabelanschlusselement an der Montagefläche mit der elektrischen Komponente verbunden ist. Ferner betrifft die Erfindung einen Schaltschrank mit mindestens einer derartigen elektrischen Komponente.

## Patentansprüche

1. Kabelanschlusselement (1) mit einer elektrischen Kontaktfläche (11) und einer Montagefläche (12), wobei die elektrische Kontaktfläche (11) mit einem Kabelschuh kontaktierbar ist, wobei das Kabelanschlusselement (1) an der Montagefläche an einem Körper (20) befestigbar ist, **dadurch gekennzeichnet , dass** die elektrische Kontaktfläche (11) und die Montagefläche (12) derart an dem Kabelanschlusselement (1) angeordnet sind, dass die Ebene (110) der elektrischen Kontaktfläche (11) und die Ebene (120) der Montagefläche (12) sich schneiden.

2. Kabelanschlusselement (1) nach Anspruch 1, wobei die Ebene (110) der elektrischen Kontaktfläche (11) und die Ebene (120) der Montagefläche (12) sich in einem Winkel (α) im Bereich zwischen 5° und 45° schneiden.

3. Elektrische Komponente (2), insbesondere ein Stromrichter (3), mit einem Kabelanschlusselement (1) nach einem der Ansprüche 1 oder 2, wobei das Kabelanschlusselement (1) an der Montagefläche (12) mit dem Körper (20) der elektrischen Komponente (2) verbunden ist.

4. Elektrische Komponente (2) nach Anspruch 3, wobei die elektrische Komponente (2) mindestens drei Kabelanschlusselemente (1) aufweist.

5. Elektrische Komponente (2) nach einem der Ansprüche 3 oder 4, wobei die Ebene (110) der elektrischen Kontaktfläche (11) und die Ebene (130) der sich in der Umgebung der elektrischen Kontaktfläche (11) befindlichen Oberfläche (13) der elektrischen Komponente (2) sich schneiden, insbesondere sich in einem weiteren Winkel (β) im Bereich zwischen 5° und 45° schneiden.

6. Schaltschrank (4) mit mindestens einer elektrischen Komponente (2) nach einem der Ansprüche 3 bis 5.
